(19) **Europäisches Patentamt European Patent Office Office européen des brevets**

(11) **EP 1 668 690 B1**

(12) **EUROPEAN PATENT SPECIFICATION**

(45) Date of publication and mention
of the grant of the patent:
**08.11.2017 Bulletin 2017/45**

(51) Int Cl.:
*G01R 31/28* (2006.01)     *G01R 31/309* (2006.01)
*H05K 1/02* (2006.01)

(21) Application number: **04770513.2**

(86) International application number:
**PCT/IL2004/000842**

(22) Date of filing: **14.09.2004**

(87) International publication number:
**WO 2005/026747 (24.03.2005 Gazette 2005/12)**

(54) **ELECTRIC DEFECTS ANALYZER DETECTING ALL DEFECTS IN PCB/MCM**

ANALYSATOR FÜR ELEKTRISCHE DEFEKTE ZUR ERKENNUNG ALLER DEFEKTE IN PCB/MCM

DISPOSITIF D'ANALYSE ELECTRIQUE DE DEFAILLANCES DETECTANT TOUTES LES
DEFAILLANCES DANS LES PCB/MCM

(84) Designated Contracting States:
**AT BE BG CH CY CZ DE DK EE ES FI FR GB GR
HU IE IT LI LU MC NL PL PT RO SE SI SK TR**

(30) Priority: **16.09.2003 US 502941 P**

(43) Date of publication of application:
**14.06.2006 Bulletin 2006/24**

(73) Proprietor: **INVISIBLE LTD**
**Tel Aviv 67021 (IL)**

(72) Inventors:
• **GITMAN, Jacob**
**76654 Rehovot (IL)**
• **DANKNER, Yair**
**44359 Kfar Saba (IL)**

• **PIKARY, Yizhak**
**42207 Netenya (IL)**

(74) Representative: **Sarpi, Maurizio**
**Studio Ferrario S.r.l.**
**Via Collina, 36**
**00187 Roma (IT)**

(56) References cited:
**EP-A1- 1 262 765        WO-A1-99/64842
WO-A1-02/067002        WO-A2-03/075322
DE-A1- 4 201 943        US-A- 5 208 528
US-A- 5 440 566        US-A1- 2002 027 941
US-A1- 2002 167 987     US-A1- 2003 137 318
US-B1- 6 340 817        US-B2- 6 820 028
US-B2- 6 840 667**

EP 1 668 690 B1

**Description**

**BACKGROUND OF THE INVENTION**

The present invention relates to the field of PCB/MCM testing technologies and methods following bare PCB/MCM production process as well as assembled boards/MCM base material. More precisely it is a PCB/MCM defects detection system using thermal diffusion technology.

At present, there are two major methods for electrically testing printed circuit boards (PCB), the traditional 'bed of nails method' and the 'flying probe method'. The bed of nails is a resistance measurements method comprised of springy pins which are electrically connected to pads on the PCB/MCM. During the test signals are applied to some of the nails, and measurements are taken at other nails. The bed of nails device needs to be especially designed, built and programmed to fit the structure of the tested PCB/MCM type. Each PCB/MCM needs a different device.

The flying probe method is based on moving pair(s)' probes physically from one point to another, touching the board and conducting the same tests made by the bed of nails but sequentially. This method eliminates the need to build the physical element required by the bed of nails method, but it still requires making physical contact with the board while conducting electrical tests. Bed of nail tests is limited to a minimum pitch size of 600 micrometer. The method of testing PCBs by flying probe is limited to a minimum pitch size of 300 micrometer. For bed of nail the test time can take between 1 and 2 minutes per PCB/MCM, for flying probes the test time is more than two hours. There is therefore a need for a PCB/MCM testing method which does not require making physical contact with the board, thus decreasing the pitch size limit and decreasing the testing time considerably and improving the tests' reliability.

Patent application No. WO 02/48720 and U. S patent application No. 10/419709 which is a continuation in part of U.S. patent application No. 09/986712 by Schlagheck et al. disclose a method and apparatus for inspecting an object and detecting defects (BGA and Flip-Chip solder joints on a PCB particularly). The method according to these applications comprises injecting a thermal stimulation on the object, capturing a sequence of consecutive infrared images of the object to record heat diffusion resulting from the heat pulse. Comparing the heat diffusion on said object to a reference and determining whether the object comprises any defects. The method is limited for detecting anomalies in solder junctions of ball-grid arrays and flip chips mounted on printed circuit boards.

DE-A-42 01 943 discloses a method and a device for testing a connection formed in an electronic component, in particular for checking the connection of an electronic component based on a comparison of information such as a shape and a temperature distribution of a soldering point acting as a plane An electronic circuit board.

WO-a-03 075 322 Border et al disclose an apparatus in which heat is applied to a conductive structure by a laser beam, another laser beam, and the temperature at or near the point of heat application is measured. The measured temperature indicates the integrity or the defectiveness of various features in the conductive structure, near the point of heat application.

The primary object of the present invention is to provide a method and apparatus for inspecting an object and detecting defects in PCBs inner layer tracks and surface layer conductors by analyzing the time interval <u>and</u> components of the spectral emission.

It is a further object of the present invention to perform anomaly tests like continuity, trace resistance, current leakage and impedance control. It can also perform tests that will represent high voltage tests.

**THE OBJECT OF THE INVENTION**

The object of the invention is to build a PCB/MCM electric test system that will not require any physical contact between the testing device and the board. This method will significantly increase the speed of testing (hundred time and more), will enable testing 5 micron pitch complicated boards and will significantly increase the reliability of the test. The system can test continuity, trace resistance, detect current leakage, impedance control and perform tests that will represent high voltage tests.

**SUMMARY OF THE INVENTION**

This object is solved by a method and a system thereof for testing PCB or MCM (DUT) according to claims 1 and 8. A method for testing PCB or MCM (DUT), by checking energy diffusion through boards tracks, said method is comprised of applying heat energy at entrance ports of the PCB/MCM then measuring in time domain the rate of energy diffusion along the tracks of the board at the terminating ports. The measurements are compared with pre-memorized values of a group of patterns that represent respective golden board results and analyzing defects automatically on the basis of learned defect test patterns.

The method of the measurement can be conducted in different frequencies bands and can be consecutive, heating a single port at a time, or more than one port simultaneously. The heating process duration is determined in accordance with the heating source type and DUT material.

A system for testing PCB/MCM or MCM (DUT), by checking energy diffusion through boards tracks, said method is comprised of controlled heat energy source for applying heat at certain ports of the PCB/MCM (entry ports), thermal Imaging means for measuring in time domain the rate of energy diffusion along the tracks of the board at terminating ports and processing means for comparing said measurements with pre-memorized values of a group of patterns that represent respective golden board results and analyzing defects automatically on the basis of learned defect test patterns.

The system include spectral image means wherein the measurement can be conducted in different frequencies bands, consecutive, heating a single port at a time or more than one port simultaneously. The heating process duration is determined in accordance with the heating source type and DUT material.

The system analysis process enables to identify the defect type according to its respective pattern.

## BRIEF DESCRIPTION OF THE DRAWINGS

These and further features and advantages of the invention will become more clearly understood in the light of the ensuing description of a preferred embodiment thereof, given by way of example only, with reference to the accompanying drawings, wherein-

Fig. 1 illustrates the typical defects detection analysis methods.

Fig. 2 - Fig. 5 illustrates several examples for different kinds of PCB/MCM defects.

Fig. 6 illustrates a track model surrounded by a bounding box, with a gap and without one.

Fig. 7 illustrates the PCB/MCM thermal modeling graph for golden board and defected one.

Fig. 8 is the system's flow chart.

Fig. 9 is the system's block diagram.

## DETAILED DESCRIPTION OF THE INVENTION

## INTRODUCTION

The fundamental physical law which we employ here is the law of conservation of energy. Consider a thin, rigid, heat-conducting body (a bar) of length l.

Let $\theta(x, t)$ indicate the temperature of this bar at position x and time t, where $0 \leq x \leq l$ and $t \geq 0$.

In other words, we postulate that the temperature of the bar does not vary with the thickness. We assume that at each point of the bar the energy density per unit volume is proportional to the temperature.

We assume that the surface of the bar is perfectly insulated so no heat can be gained or lost through it, except of the input and output ports.

It says that the rate of change of energy in any finite part of the bar is equal to the total amount of heat flowing into this part of the bar.

This equation is known as the "heat equation", and it describes the evolution of temperature within a finite, one-dimensional, homogeneous continuum, with no internal sources of heat, subject to some initial and boundary conditions:

$$\frac{\partial \theta}{\partial t} = \gamma \frac{\partial^2 \theta}{\partial x^2}, \qquad 0 < x < l,$$

$$\gamma = \frac{\kappa}{c}.$$

$\gamma$ is known as the diffusion coefficient, Heat capacity c(x) and the thermal conductivity $\kappa(x)$ are point independent.

We assume that the PCB/MCM conductors are finite, one-dimensional, homogeneous continuum and perfectly insulated bars but we can change this assumption, considering that the channel is not perfectly insulated, by changing the "Heat Equation" respectively.

Solving the heat equation for the PCB/MCM conducting tracks, we conclude that the rate at which heat flows through the track at position x and time t, depend on the quality and characteristic of the track. Damage or a defect along the track will cause a change in the density of the material and in the diffusion coefficient, leading to a change in the rate of the heat flow. So any physical change in the track will lead to a change in the time interval of the heat equilibrium between both ends of the track.

**Heat** is another form of energy. When an object is being heated its particles move faster and the molecules are vibrating at a range of frequencies (energy spectrum), depending on the substance and the shape of the object.

The system performs spectral analysis of the heat energy emitted from the end of the track and any damage or a defect along the track will cause a change in the frequency components of the energy spectrum.

## TEST METHOD

The entrance ports of the PCB/MCM tracks are illuminated, causing heat transfer along the tracks. The entrance ports are beamed selectively or mutually by a regular light source or a laser beam. The temperature rise at the entrance ports is affected by the illumination duration, in compliance with the PCBs material specifications and the heat source. PCB/MCM tracks are made of copper with some degree of contamination. As a result of the heating process at the entrance ports, a heat wave propagates along the track. The heat is diffused along the tracks and the exit ports. For analyzing the diffusion at the exit port of the track, the respective diffusion equation (heat equation) for the specific material is applied using the respective diffusion coefficient. The rate of the diffusion along the tracks depends on the diffusion coefficient. This coefficient value for the specific material is proportional to the heat conduction coefficient, and inverse-proportional to the density of the material and the heat intensity.

This rate of diffusion along the tracks depend also on the initial conditions (rate of change of the temperature at the end ports of the track) as well as on the initial conditions which indicate what was the temperature at t=0 along the track.

The results of rise in temperature at exit port/s, occur in time delay with respect to temperature rise at the entrance port. The temperature measurement with respect to time at the exit port/s is a crucial parameter for the analysis. The radiant flux emitted from the exit port is also **wavelength** dependent and proportional to the emissivity of the specific copper track. Emissivity of metals is proportional to their density and inverse-proportion to their temperature. The analysis of the exit ports is performed by using an infrared spectrometer and a thermal imaging apparatus. The measurements are taken with respect to a time domain at a specific wavelength or with respect to a time domain and an integration of the whole spectral emission. Any existing defect along the track will affect the heat diffusion along the track and cause time domain changes in thermal characteristics at the exit port. During the manufacturing process of the device, it is initially calibrated both for defect free tracks and for tracks which exceeds predetermined tolerance (as defined by the net-list IPC-D350/356). The data obtained from the calibration process is used as reference for detecting defects on the board.

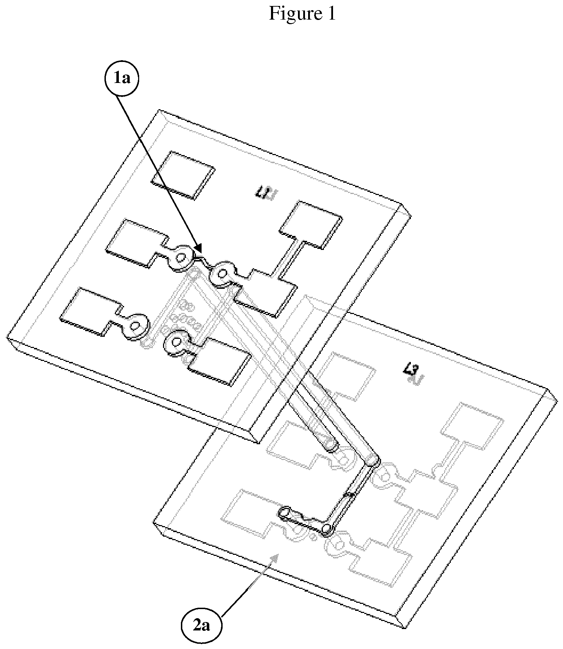

Figure 1 illustrates the structure of the PCB/MCM: layers and tracks. (1a) Upper (L1) and (2a) lower (L4) layers can be equally treated as input or readout layer, individually or simultaneously.

According to the present invention, the method can **detect** and **identify** the following electrical phenomena:

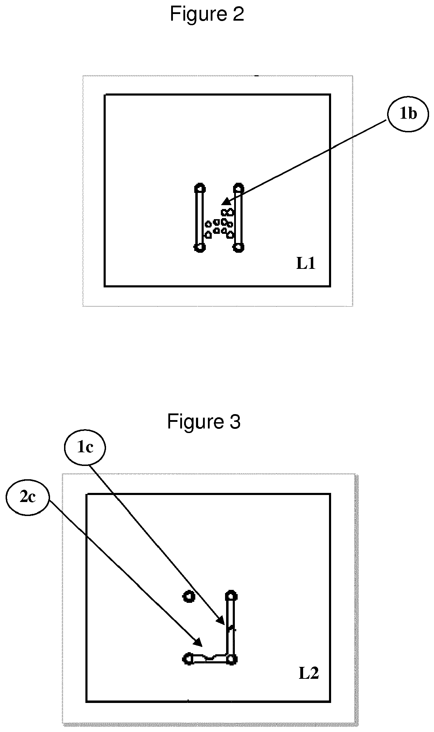

> Irregular impedance, Current leakage, Voltage breakthrough, Continuity test:
>
>> Short/Open and out of range Resistance between traces or layers and also between planes. Several types of defects detected are indicated in Fig. 2, Fig. 3, Fig. 4 and Fig. 5.

Figure 2 illustrates the upper layer (L1) of the PCB/MCM. It describes one of the most common defects, a Shortage (1b) between channels.

Figure 3 illustrates the second layer (L2) of the PCB/MCM. It demonstrates how the existence of residues can cause current leakage (1c) between channels and low resistance.

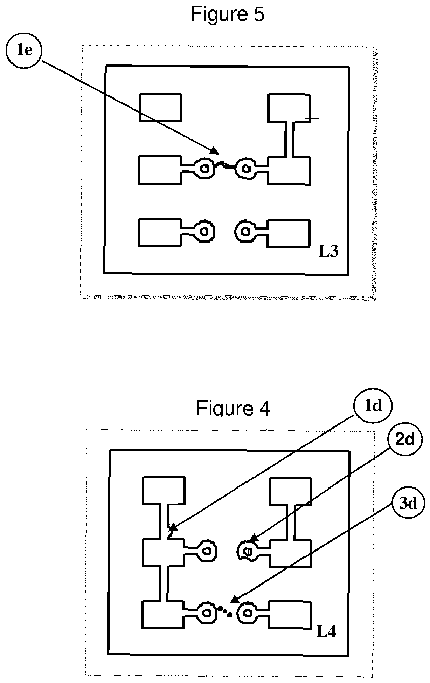

Figure 4 illustrates the forth layer (L4) of the PCB/MCM. It describes a thick copper conductor (1d) that causes low ohm resistance, an 'eaten' via (2d) that lead to high ohm resistance and Breakthrough/leakage (3d) caused by existence of residues between pads.

Figure 5 illustrates the third layer (L3) of the PCB/MCM. It indicates an Open channel (1e) caused by etching malfunction due to unclear photo resist - Reston and Low resistance (2) caused by etching malfunction due to unclear photo resist - Reston.

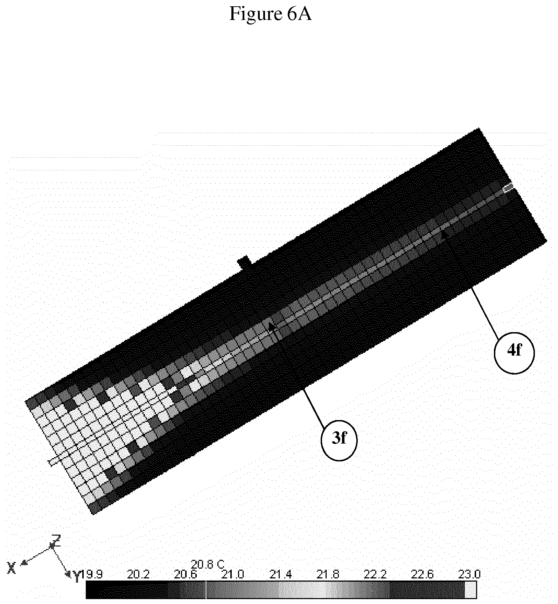

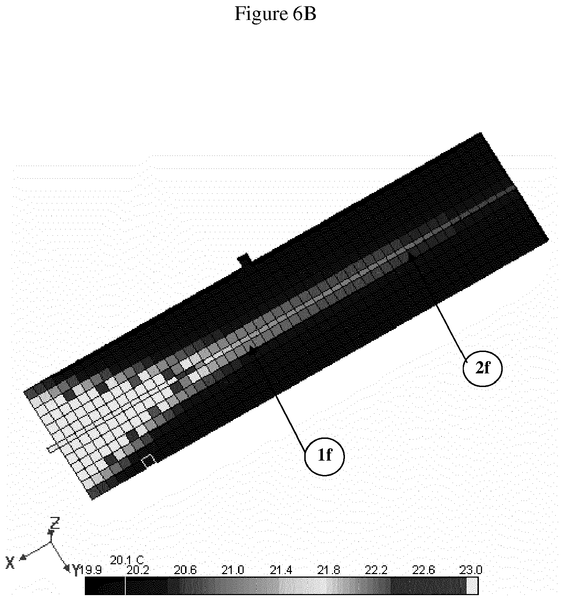

Figures 6a, 6b illustrate the gap influence on the PCB/MCM surface temperature distribution along the central line. The simulated PCB illustrates how a gap in the track causes a change in the diffusion rate when Comparing (1f) to (3f) and (2f) to (4f). The difference of temperatures between a golden board and a defect PCB is quite obvious.

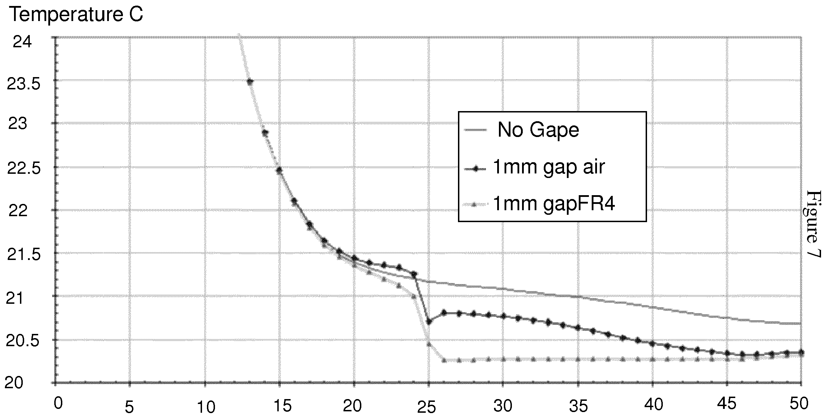

Figure 7 illustrates a graph of the simulation of a break in a track which shows the temperature as a function of the distance from the heat source at a specific time (0.4 seconds), the heat diffusion graph of the gap is compared to a graph of a perfect track. The gap in the track is filled with air or FR4 causing heat distribution along the central line to be different from a golden board. The type material found in the gap influence the response of the heat distribution.

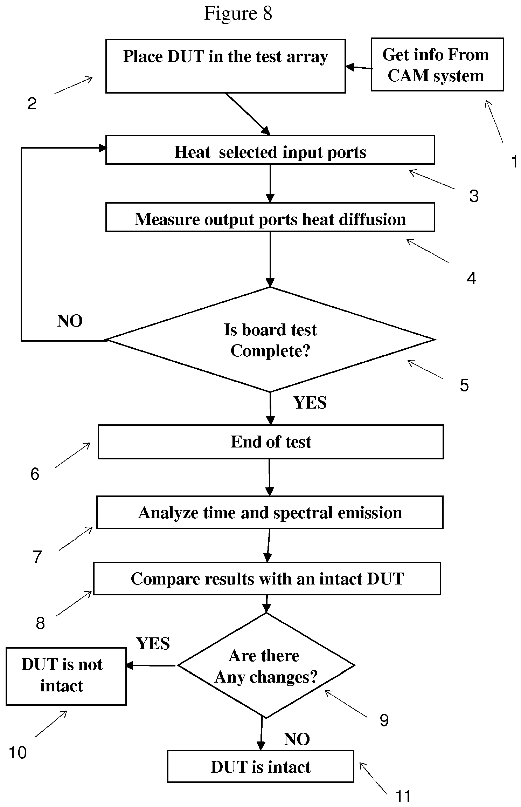

Figure 8 illustrates the flow chart of the test procedure. First the testing system receives the PCB/MCM datum from the CAM (computer aided manufacturing) system (step 1), then the DUT (device under test - i.e. PCB) is placed in the test array (step 2) and the entrance ports of the PCB/MCM tracks are illuminated (step 3), causing heat transfer along the tracks.

At the next step (4), temperature measurement are taken as a function of time at the exit in a serial mode (one port at a time) or in a parallel mode (altogether). Additionally spectral emission pattern measurements are also being conducted at the exit port or ports.

The test procedure can include a number of stages, depends on whether the entrance ports are beamed selectively or mutually. After each stage, the system examines (step 6) if it has finished checking all the tracks and continues until all tracks were tested.

The test results (diffusion time and spectral emission) are analyzed (step 8) after the test is completed. The system then compares (step 9) the test obtained datum with datum that was initially obtained from the calibration process for defect free tracks and for tracks which exceeds determined tolerance.

The system can **detect** and **identify** several electrical phenomena like Irregular impedance, Current leakage and Voltage breakthrough.

If the changes between the DUT and the referenced PCB/MCM are outside the tolerance boundaries, the tested PCB/MCM is considered damaged and unfit for use (step 10) otherwise the PCB/MCM is fully intact and ready for use (step 11).

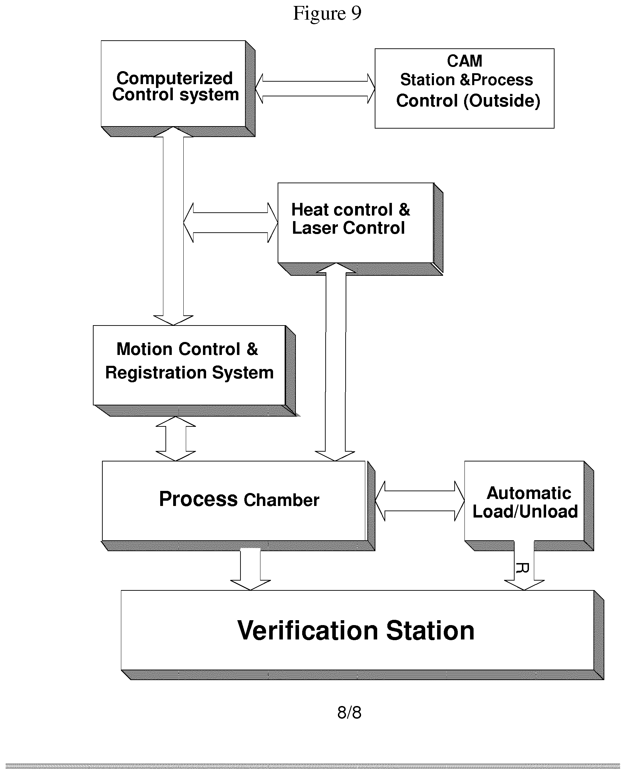

Figure 9 illustrates the block diagram of the test procedure. The entire electric test system is connected to the CAM (computer aided manufacturing) system. The CAM system provides the specifications of the particular PCB/MCM (i.e. DUT) that undergoes the test procedure, to the computerized control system (CCS). The CCS controls the heating source (e.g. laser) used for illuminating the input ports and the motion control. The PCB/MCM is placed in the process chamber by the automatic load/unload unit and undergoes the process of diffusing energy through the board inner layer tracks terminating at the end of the channel tracks. The raw results are recorded, analyzed and compared to a golden board (pre analyzed or simulated one) in the verification process.

## HEATING SOURCES

The heating source apparatus may be a xenon flash lamp, incandescent lamp, laser, LED, arc lamps or any other light source that fits the testing requirements.
The type of heating source is selected according to several criteria like the illumination of the tracks, the duration of the illumination and the use of collimating optics between the source and the entrance ports.
The illumination of the tracks entrance ports is preformed either simultaneously or one at a time and the duration of the illumination can vary from several milliseconds to several seconds in accordance with heating source type and PCB/MCM material.

## TEST PROCESS WORKFLOW AND ANALYSIS

The testing procedure at the exit ports changes according to the analysis measuring method. An infrared spectrometer via collimating optics is used to analyze the temperature of each exit port with respect to time and wavelength.
The same method can be utilized by checking a spectral window with respect to time instead of a single wavelength. A different procedure uses a thermal imaging device to analyze each or all exit ports simultaneously. Any combination of the aforementioned different methods can be used.
Test results of the exit ports are compared to a database of an identical perfect track.
"Thermal pictures" is a known technology in the context of software for picture analysis. The present invention is based on thermal conduction of copper, or any other metal or mixture of metals of which the track is made of and the analysis of the temperature through the infrared emission at the edges (exit ports of the tracks). Defects along the tracks will affect the heat conduction and therefore will change the thermal picture at the exit port. These defects ultimately change the spectral emission at the exit ports. The analysis of the spectrum with respect to time enables spotting and identifying those defects and their severity.
While the above description contains many specifications, these should not be construed as limitations on the scope of the invention, but rather as exemplifications of the preferred embodiments. Those skilled in the art will envision other possible variations that are within its scope. Accordingly, the scope of the invention should be determined not by the embodiment illustrated, but by the appended claims.

## Claims

1. A method for identifying defects in a Printed Circuit Board (PCB) or Multi Chip Module (MCM) comprising a multiplicity of conductive tracks, said tracks comprising input ports and output ports, said method comprising the steps of:

   a) applying heat to selected input ports (3) of said PCB or MCM, using a controlled heat energy source, each track having heat applied there-through is referred to as a tested track;
   b) measuring in the time domain the rate of energy diffusion along said tested tracks of said board at said output ports by measuring the spectral emission of IR radiation (4) with respect to time and wavelength using an infrared spectrometer for generating an energy spectrum;
   c) comparing said measurement results with pre-memorized values of a group of patterns, which represent respective golden boards results (8), by processing means; and
   d) automatically detecting defects in each tested track, using the said comparison with golden board patterns, by identifying changes in the frequency components of said energy spectrum and in the rate of heat energy diffusion, wherein said method enables therefore to identify defects occurring along the entire respective tested conductive track, by:

   • accessing said input ports on the PCB or MCM, and
   • analyzing heat-related data pertaining to said output ports on the PCB or MCM.

   e) automatically analyzing defects on the tested track, based on learned defect test patterns.

2. The method of claim 1, in which said controlled heat energy source is a laser.

3. The method of claim 1 wherein the measurements are consecutive, heating a single input port at a time.

4. The method of claim 1 wherein the measurements are conducted at more than one output port simultaneously.

5. The method of claim 1 wherein the heat is applied simultaneously at different input ports.

6. The method of claim 1 wherein the heating process duration is determined in accordance with the heating source type and the PCB/MCM (DUT) material.

7. The method of claim 1 wherein the golden board is:

   a pre analyzed perfect PCB/MCM, or
   a simulated PCB/MCM.

8. A system for identifying defects in a Printed Circuit Board (PCB) or Multi Chip Module (MCM) comprising a multiplicity of conductive tracks, said tracks comprising input ports and output ports, said system comprising:

   a. a controlled heat energy source for applying in use heat to selected input ports of said PCB or MCM (3);
   b. an infrared spectrometer for measuring in the time domain the rate of energy diffusion along said tracks by measuring the spectral emission of IR radiation in respect to time and wavelength, on said output ports of said tested tracks for generating an energy spectrum;
   c. processing means for carry out the steps c. to e. of the method according to claim 1.

9. The system of claim 8, wherein the PCB/MCM (DUT) is:

   before assembly, or
   after assembly

10. The system of claim 9, wherein the measurements are consecutive, heating a single input port at a time.

11. The system of claim 9, wherein the measurements are conducted at more than one output port simultaneously.

12. The system of claim 9, wherein the heat is applied simultaneously at different input ports.

13. The system of claim 9, wherein the heating process duration is determined in accordance with the heating source type and PCB/MCM (DUT) material.

14. The system of claim 9, wherein the golden board is a pre analyzed perfect PCB/MCM.

15. The system of claim 9, wherein the golden board is a simulated PCB/MCM.

**Patentansprüche**

1. Verfahren zum Identifizieren von Fehlern auf einer gedruckten Schaltkarte (PCM) oder einem Multi-Chip-Modul (MCM) mit einer Vielzahl von leitenden Bahnen, die Eingangs- und Ausgangsanschlüssen aufweisen, wobei das Verfahren die Schritte umfasst:

   a) Zuführen von Wärme zu ausgewählten Eingangsanschlüssen (3) der PCB oder des MCM unter Verwendung einer gesteuerten Wärmeenergiequelle, wobei auf jede Bahn, durch die Wärme hindurchgeführt wurde als getestete Bahn Bezug genommen wird;
   b) Messen der Energiediffusionsrate entlang der getesteten Bahnen der Schaltkarte an den Ausgangsanschlüssen in der Zeitdomäne durch Messen der spektralen IR-Strahlungsemission (4) unter Bezug auf Zeit und Wellenlänge unter Verwendung eines Infrarotspektrometers zur Erzeugung eines Energiespektrums;
   c) Vergleichen der Messergebnisse mit vorab gespeicherten Werten einer Gruppe von Mustern, die jeweilige Goldene-Platinen-Ergebnisse (8) darstellen, durch Verarbeitungsmittel; und
   d) automatisches Ermitteln von Fehlern in jeder getesteten Bahn unter Verwendung des Vergleichs mit den Goldene-Platinen-Mustern durch identifizieren von Änderungen der Frequenzkomponenten des Energiespektrums und der Energiediffusionsrate, wobei das Verfahren es dadurch ermöglicht, Fehler zu identifizieren, die entlang der gesamten jeweiligen getesteten leitenden Bahn auftreten, durch:

      • Zugreifen auf die Eingangsanschlüsse auf der PCB oder dem MCM, und
      • Analysieren der wärmebezogenen Daten, die zu den Ausgangsanschlüssen der PCB oder des MCM gehören;

   e) automatisches Analysieren von Fehlern auf der getesteten Bahn auf Grundlage eines erlernten Fehlertestmusters.

2. Verfahren nach Anspruch 1, bei dem die gesteuerte Wärmeenergiequelle ein Laser ist.

3. Verfahren nach Anspruch 1, wobei die Messungen unter Erwärmen eines Eingangsanschlusses nach dem andern aufeinanderfolgen.

4. Verfahren nach Anspruch 1, wobei die Messungen gleichzeitig an mehr als einem Ausgangsanschluss durchgeführt werden.

5. Verfahren nach Anspruch 1, wobei die Wärme gleichzeitig unterschiedlichen Eingangsanschlüssen zugeführt wird.

6. Verfahren nach Anspruch 1, wobei die Heizprozessdauer in Übereinstimmung mit dem Typ der Heizquelle und des PCB/MCM (DUT)-Materials ermittelt wird.

**7.** Verfahren nach Anspruch 1, wobei die goldene Platine folgendes ist:

eine vorab analysierte perfekte PCB bzw. ein vorab analysiertes perfektes MCM, oder eine simulierte PCB bzw. ein simuliertes MCM.

**8.** System zum Identifizieren von Fehlern auf einer gedruckten Schaltkarte (PCM) oder einem Multi-Chip-Modul (MCM) mit einer Vielzahl von leitenden Bahnen, die Eingangs- und Ausgangsanschlüssen aufweisen, wobei das System aufweist:

a. eine gesteuerte Wärmequelle zum nutzungsabhängigen Zuführen von Wärme zu ausgewählten Eingangsanschlüssen der PCB oder des MCM (3);
b. ein Infrarotspektrometer zum Messen der Energiediffusionsrate entlang den Bahnen in der Zeitdomäne durch Messen der spektralen IR-Strahlungsemission in Bezug auf Zeit und Wellenlänge an den Ausgangsanschlüssen der getesteten Bahnen zur Erzeugung eines Energiespektrums;
c. ein Verarbeitungsmittel zum Ausführen der Schritte c. bis e. des Verfahrens nach Anspruch 1.

**9.** System nach Anspruch 8, wobei die PCB/MCM (DUT) erfolgt:

vor der Montage oder
nach der Montage.

**10.** System nach Anspruch 9, wobei die Messungen unter Erwärmen eines Eingangsanschlusses nach dem andern aufeinanderfolgen.

**11.** System nach Anspruch 9, wobei die Messungen gleichzeitig an mehr als einem Ausgangsanschluss durchgeführt werden.

**12.** System nach Anspruch 9, wobei die Wärme gleichzeitig unterschiedlichen Eingangsanschlüssen zugeführt wird.

**13.** System nach Anspruch 9, wobei die Heizprozessdauer in Übereinstimmung mit dem Typ der Heizquelle und des PCB/MCM (DUT)-Materials ermittelt wird.

**14.** System nach Anspruch 9, wobei die goldene Platine eine vorab analysierte perfekte PCB bzw. ein vorab analysiertes perfektes MCM ist.

**15.** System nach Anspruch 9, wobei die Goldene Platine eine simulierte PCB bzw. ein simuliertes MCM ist.

**Revendications**

**1.** Procédé pour identifier des défauts dans une carte de circuits imprimés (PCP) ou un module à puces multiples (MCM) comprenant une multiplicité de pistes conductrices, lesdites pistes comprenant des ports d'entrée et des ports de sortie, ledit procédé comprenant les étapes suivantes :

a) l'application de chaleur à des ports d'entrée sélectionnés (3) de ladite PCB ou dudit MCM, en utilisant une source d'énergie thermique commandée, chaque piste ayant une chaleur appliquée à travers celle-ci étant désignée comme une piste testée ;
b) la mesure dans le domaine temporel du taux de diffusion d'énergie le long desdites pistes testées de ladite carte au niveau desdits ports de sortie en mesurant l'émission spectrale de rayonnement IR (4) par rapport au temps et à la longueur d'onde en utilisant un spectromètre infrarouge pour générer un spectre énergique ;
c) la comparaison desdits résultats de mesure avec des valeurs pré-mémorisées d'un groupe de modèles, qui représentent des résultats de cartes d'or respectifs (8), par des moyens de traitement ; et

d) la détection automatique de défauts dans chaque piste testée, en utilisant ladite comparaison avec des modèles de carte d'or, en identifiant des variations des composantes de fréquence dudit spectre énergétique et du taux de diffusion d'énergie thermique, dans lequel ledit procédé permet ainsi d'identifier des défauts se produisant le long de toute la piste conductrice testée respective, par :

- l'accès auxdits ports d'entrée sur la PCB ou le MCM, et
- l'analyse de données liées à la chaleur relatives auxdits ports de sortie sur la PCB ou le MCM,

e) l'analyse automatique de défauts sur la piste testée, sur la base de modèles de test de défauts acquis par apprentissage.

**2.** Procédé selon la revendication 1, dans lequel ladite source d'énergie thermique commandée est un laser.

**3.** Procédé selon la revendication 1, dans lequel les mesures sont consécutives, en chauffant un seul port d'entrée à la fois.

**4.** Procédé selon la revendication 1, dans lequel les mesures sont effectuées simultanément au niveau de plus d'un port de sortie.

**5.** Procédé selon la revendication 1, dans lequel la chaleur est appliquée simultanément au niveau de différents ports d'entrée.

**6.** Procédé selon la revendication 1, dans lequel la durée du processus de chauffage est déterminée en fonction du type de source de chauffage et du matériau de PCB/MCM (DUT).

**7.** Procédé selon la revendication 1, dans lequel la carte d'or est :

   une PCB/MCM parfaite pré-analysée, ou
   une PCB/MCM simulée.

**8.** Système pour identifier des défauts dans une carte de circuits imprimés (PCP) ou un module à puces multiples (MCM) comprenant une multiplicité de pistes conductrices, lesdites pistes comprenant des ports d'entrée et des ports de sortie, ledit système comprenant :

   a. une source d'énergie thermique commandée pour appliquer en service de la chaleur à des ports d'entrée sélectionnés de ladite PCB ou dudit MCM (3) ;
   b. un spectromètre infrarouge pour mesurer dans le domaine temporel le taux de diffusion d'énergie le long desdites pistes en mesurant l'émission spectrale de rayonnement IR par rapport au temps et à la longueur d'onde, sur lesdits ports de sortie desdites pistes testées pour générer un spectre énergique ;
   c. des moyens de traitement pour exécuter les étapes c. à e. du procédé selon la revendication 1.

**9.** Système selon la revendication 8, dans lequel le PCB/MCM (DUT) est :

   avant l'assemblage, ou
   après l'assemblage.

**10.** Système selon la revendication 9, dans lequel les mesures sont consécutives, en chauffant un seul port d'entrée à la fois.

**11.** Système selon la revendication 9, dans lequel les mesures sont effectuées simultanément au niveau de plus d'un port de sortie.

**12.** Système selon la revendication 9, dans lequel la chaleur est appliquée simultanément au niveau de différents ports d'entrée.

**13.** Système selon la revendication 9, dans lequel la durée du processus de chauffage est déterminée en fonction du type de source de chauffage et du matériau de PCB/MCM (DUT).

**14.** Système selon la revendication 9, dans lequel la carte d'or est une PCB/MCM parfaite pré-analysée.

**15.** Système selon la revendication 9, dans lequel la carte d'or est une PCB/MCM simulée.

Figure 1

Figure 2

L1

1b

Figure 3

1c

2c

L2

Figure 5

L3

Figure 4

L4

Figure 6A

Figure 6B

Figure 7

EP 1 668 690 B1

Figure 8

```
                    ┌──────────────────────────┐      ┌─────────────────┐
                    │ Place DUT in the test array │◄─────│  Get info From  │
                    └──────────────────────────┘      │   CAM system    │
         2  ↗                    │                     └─────────────────┘
                                 │                              ↖
                                 ▼                               1
         ┌────────────────────────────────────────┐
     ┌──►│         Heat  selected input ports       │
     │   └────────────────────────────────────────┘ ↖
     │                           │                    3
     │                           ▼
     │   ┌────────────────────────────────────────┐
     │   │      Measure output ports heat diffusion  │
     │   └────────────────────────────────────────┘ ↖
     │                           │                    4
     │   NO                      ▼
     │         ◄────────◇                 ◇
     └─────────        Is board test
                       Complete?              ↖
                             ◇           ◇     5
                             │
                             │ YES
                             ▼
         ┌────────────────────────────────────────┐
         │               End of test                │
  6  ↗   └────────────────────────────────────────┘
                             │
                             ▼
         ┌────────────────────────────────────────┐
         │     Analyze time and spectral emission   │
  7  ↗   └────────────────────────────────────────┘
                             │
                             ▼
         ┌────────────────────────────────────────┐
         │     Compare results with an intact DUT   │
  8  ↗   └────────────────────────────────────────┘
                             │
          YES                ▼
  ┌────────────┐ ◄──◇     Are there    ◇
  │ DUT is not │        Any changes?
  │   intact   │          ◇        ◇   ↖
  └────────────┘               │         9
       ↗                       │ NO
  10                           ▼
              ┌────────────────────────┐
              │      DUT is intact       │ ↖
              └────────────────────────┘   11
```

Figure 9

| Computerized Control system | | CAM Station &Process Control (Outside) |

Heat control & Laser Control

Motion Control & Registration System

| Process Chamber | | Automatic Load/Unload |

Verification Station

8/8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 0248720 A
- US 10419709 B
- US 986712 A, Schlagheck
- DE 4201943 A
- WO 03075322 A, Border